# EUROPEAN PATENT SPECIFICATION

(11) **EP 0 342 656 B1**
(45) Date of publication and mention of the grant of the patent: **19.01.1994**
(21) Application number: 89108888.2
(22) Date of filing: 17.05.1989
(51) Int. Cl.: H01L 33/00, H01S 3/19, C30B 25/02

(54) **Method of manufacturing a compound semiconductor light emitting device**
Herstellung einer aus einem Verbindungshalbleiter bestehenden lichtemittierenden Vorrichtung
Méthode de fabrication d'un dispositif électroluminescent à semi-conducteur composé

(30) Priority: 17.05.1988 JP 118146/88; 06.07.1988 JP 166698/88
(43) Date of publication of application: 23.11.1989
(73) Proprietor: MITSUBISHI RAYON KABUSHIKI KAISHA, Tokyo-To (JP)
(72) Inventor: Ichimura, Kiyoshi, Kawasaki-Shi Kanagawa-Ken (JP); Tsushi, Akihito, Kawasaki-Shi Kanagawa-Ken (JP); Kawanishi, Hideo, Machida-Shi Tokyo-To (JP)
(74) Representative: Klunker . Schmitt-Nilson . Hirsch

(56) References cited:
- APPLIED PHYSICS LETTERS, vol. 46, no. 1, 1st January 1985, pages 7-9, American Institute of Physics, New York, US; K. KOBAYASHI et al.: "626.2-nm pulsed operation (300K) of an AlGalnP double heterostructure laser grown by metalorganic chemical vapor deposition"
- JAPANESE JOURNAL OF APPLIED PHYSICS, SUPPLEMENTS (18th Int. Conf. on Solid State Devices and Materials, Tokyo, 1986) 20th-22nd August 1986, Tokyo, pages 149-152; T. SUZUKI: "AlGaInP visible semiconductor lasers grown by metalorganic vapor phase epitaxy"
- JAPANESE JOURNAL OF APPLIED PHYSICS/SUPPLEMENTS, vol. 26, 1987, Supplement 26-4, pages 101-105, Tokyo, JP; M. IKEDA et al.: "AlGaInP visible semiconductor lasers"
- APPLIED PHYSICS LETTERS, vol. 52, no. 16, 18th April 1988, pages 1329-1331, American Institute of Physics, New York, NY, US; D.W. NAM et al.: "Short-wavelength ( 625 nm) room-temperature continuous laser operation of In0.5(AlxGa1-x)0.5P quantum well heterostructures"
- PATENT ABSTRACTS OF JAPAN, vol. 12, no. 20 (E-575)[2867], 21st January 1988; & JP-A-62 179 192
- PATENT ABSTRACTS OF JAPAN, vol. 11, no. 286 (E-541)[2733], 16th September 1987; & JP-A-62 84 582
- PATENT ABSTRACTS OF JAPAN, vol. 8, no. 39 (E-228)[1476], 21st February 1984; & JP-A-58 197 722

## Description

### BACKGROUND OF THE INVENTION

This invention relates to a method of forming a light emitting device including a compound semiconductor, and more particularly to a method of forming a light emitting device of a III-V compound semiconductor having uniform and high light emitting intensity, such as a semiconductor laser in particular.

The III-V compound semiconductors are utilized as the material of optoelectronic devices for converting an electrical input into an optical output by applying a forward-bias to the pn junction of the semiconductor, e.g., a semiconductor laser adapted to take out a stimulated emission light produced by recombination of the carriers, or a light emitting diode adapted to take out a spontaneous emission light produced by recombination of the carriers.

The principle and the fundamental structure of the semiconductor laser is described in detail in the literature by Casey and Panish (H.C. Casey, Jr., M.B. Panish: Heterostructure lasers, Academic Press, New York (1978)).

Since such semiconductor lasers are small, light, and are easy to handle, attention is focused thereupon as a light source used for information equipment such as video disks, measurement equipment, optical communication equipment, and the like in place of the He-Ne lasers which have been conventionally used. A great interest in particularly short wavelength semiconductor lasers is taken from the viewpoint of improvements in the performance of the system. For the material capable of oscillating at a short wavelength of about 600 nm band and less, there are III-V compound semiconductors, and especially AℓGaInP mixed crystal is particular.

(Al_{z}Ga_{1-z})ₓIn₁₋ₓP semiconductor lasers grown by MOVPE (metalorganic vapor phase epitaxy) or MOCVD (metalorganic chemical vapor deposition) and MBE (molecular beam epitaxy) are known from:
- T. Suzuki, Jap. J. of Appl. Phys.; Supplements (18th Int. Conf. on Solid State Devices and Materials) Tokyo, 10th-22nd August 1986, pages 149-152;
- K. Kobayashi et al., Appl. Phys. Lett. 46(1), 7 (1. Januar 1985); and
- D. W. Nam et al., Appl. Phys. Lett. 52(16), 1329 (18 April 1988).

These lasers have a lattice-matching number x=0.5 and a number z between 0.17 and 0.3. Their lasing wavelengths are between 625nm and 690 nm. Source gases were introduced into a horizontal reactor. Source materials were, e.g. trimethylaluminum, trimethylgallium, thrimethylindium and PH₃.

The manufacturing process of the III-V compound semiconductor is as follows. First, metalorganic compounds including the group III materials and hydride compounds of group V materials constituting the III-V compound semiconductor, are transported onto a substrate under a high temperature condition. They are caused to react and undergo crystal growth on the substrate by the metalorganic chemical vapor deposition (MOCVD) method in addition to MBE (molecular beam epitaxy) method. Thus, the III-V compound semiconductor is obtained as a crystal film. However, satisfactory crystals could not necessarily be obtained and control of the composition was difficult.

On the contrary, various methods of manufacturing satisfactory crystals with good controllability have been proposed. For example, for the method of manufacturing a crystal film of the III-V compound semiconductor on the substrate in a manner as stated above, there are a transporting method of a supply gas including phosphine and the group III organicmetal compound at a gas velocity of more than 40 cm/sec (Japanese patent application laid open No. 156592/83), a method of growing the AℓGaInP layer on the GaAs substrate surface so adjusted that the surface thereof is inclined from the (100) plane to both directions of the (011) surface and the (011) surface by an angle of 0.5 to 4°, respectively (Japanese patent application laid open No. 65996/87), and a method of controlling the growth rate of material gas on the GaAs substrate under conditions of a gas pressure of more than 100 Torr (1 Torr = 133,32 Pa) and a temperature of 650 to 720°C (Japanese patent application laid open No. 23314/88). The reason why the gas flow rate within the reactive tube is equal to 40 cm/sec or more, and the reason why the pressure within the tube is 100 Torr or more is that side reaction takes place until the material gas comes onto the substrate from the time when the material gas has been introduced into the reactive tube, therefore failing to give a compound semiconductor having the desired characteristics.

However, in the case where the AℓGaInP crystal film obtained with the conventional manufacturing method is used as an active layer of the light emitting device such as a semiconductor laser, when the Aℓ composition ratio is increased, the oscillation wavelength can be equal to a short wavelength of about 600 nm, but the oscillation intensity to be maintained at a high level is lowered.

Furthermore, since the gas pressure is high and the gas flow rate is very high in the conventional method, the quantity of material gas used necessary per each compound semiconductor is increased, resulting in increased manufacturing cost. In addition, a large quantity of used material gas, i.e., exhaust gas may be produced, large investment and/or troublesome operation are required for treatment of the exhaust gas which is poisonous.

This invention has been made under the above-described background, and its object is to provide a method of manufacturing a AℓGaInP light emitting device having an oscillation wavelength in the short wavelength of 600 nm band and having a sufficient oscillation intensity, which method makes it possible to reduce the quantity of material gas used, and to lessen the burden on exhaust gas treatment.

### SUMMARY OF THE INVENTION

A method of manufacturing a compound semiconductor light emitting device according to this invention is defined in claim 1. Preferred embodiments are defined in claims 2 to 4.

In accordance with the method of manufacturing a compound semiconductor crystal film according to this invention for a semiconductor light emitting device, since group V material gas is at a transported low concentration into the reactive tube under conditions of slow feed flow rate and low gas pressure, the quantity of material used may be reduced. Thus, the manufacturing cost is reduced and the troublesomeness of the exhaust gas treatment is lessened.

In addition, by the gentle reactive conditions of the slow flow rate and the low gas pressure, and an ingenious device to rotate the substrate surface at a slightly inclined angle, a thin film uniformly grown on the substrate can be satisfactorily obtained.

The semiconductor light emitting device having a compound semiconductor crystal film manufactured according to this invention has an oscillating wavelength in the 600 nm band, particularly at least in the short wavelength of 606 nm.

### BRIEF DESCRIPTION OF THE DRAWINGS

FIG. 1 is a side cross sectional view showing an embodiment of an apparatus for manufacturing a compound semiconductor used in a manufacturing method of this invention.

FIG. 2 is a graph showing the measured results of photoluminescence of a compound semiconductor crystal film obtained by the manufacturing method of this invention, and

FIG. 3 is a perspective view schematically showing the basic construction of a semiconductor, laser of a compound semiconductor light emitting device having a compound semiconductor crystal film manufactured according to this invention.

### DETAILED DESCRIPTION OF THE INVENTION

### Manufacturing method

The method of manufacturing a compound semiconductor according to this invention is directed to a method of forming an AℓGaInP compound semiconductor crystal film on a substrate under the conditions of specified material feed and the crystal growth, to therefore manufacture a compound semiconductor light emitting device.

For the material used in this manufacturing method, there are metalorganic compounds including group III materials and hydrides of phosphorous constituting the AℓGaInP compound semiconductor of the final object. For an actual example of an metalorganic compound containing aluminum, there is alkyl aluminum such as triethyl aluminum, trimethyl aluminum, or ethylmethyl aluminum. For the organic metal compound containing gallium, there is alkyl gallium such as triethyl gallium, trimethyl gallium, or ethylmethyl gallium. For an actual example of the metalorganic compound containing indium, there is alkyl indium such as triethyl indium, trimethyl indium, or ethylmethyl indium. For an example of hydride of phosphorous, there is phosphine.

In addition to the above-mentioned materials, various materials may be used according to need.

The feed of material in this invention is conducted in a manner whereby material in the form of a mixture of materials in their gaseous phases is transported into the lateral type reactive tube at a gas velocity of less than 30 cm/sec, preferably 18 to 23 cm/sec, and at a pressure within the tube of less than 60 Torr, preferably 45 to 55 Torr. By the low concentration material feed under these conditions, an uniform and thin monocrystalline film can be formed on the substrate.

In the manufacturing method of this invention, the substrate on which a target crystal film is formed may be GaAs substrate of (100) plane set at a predetermined temperature, GaAs substrate of (100) plane having various epitaxial grown layers formed on the substrate surface, or the like, and its form or configuration and dimension may be arbitrarily determined.

### Manufacturing apparatus

A manufacturing apparatus used in the manufacturing method of this invention is provided with a lateral type reactive tube through which a mixture of material gases flows in a state considered as a laminar flow in a horizontal direction as since the lateral type reactive tube is used in this invention, there is no possibility that the reactive gas heated in the vicinity of the place where the substrate is provided may be circulated by convection upwardly and downwardly as in the vertical type reactive tube, therefore making it possible to uniformly grow a crystal of the compound semiconductor on the substrate surface.

The mixture of material gases admitted into the lateral type reactive tube is transported under the conditions of the flow rate and pressure described above.

The substrate surface on which the crystal film is grown, is inclined so as to have an angle of 3 to 45°, preferably 3 to 10° relative to the direction of flow of the mixture of material gases, i.e., substantially horizontal direction. This may be implemented by mounting the substrate table (graphite susceptor) for mounting the substrate thereon in a manner as stated above.

As just described above, an employment of the device so that the substrate surface is inclined can overcome the inconveniences encountered with the case where the substrate is horizontally mounted, namely that the crystal growth rate is considerably slow, and that a large quantity of poisonous gas is produced.

In this invention, the substrate surface on which the crystal is to be grown is rotated about the axis in a direction perpendicular to the substrate surface. Such a rotation may be conducted by rotating the substrate table on which the substrate is mounted. By rotating the substrate surface in this way, the growth generation conditions upstream of the gas flow on the substrate surface and that downstream thereof can be equalized. Thus, a compound semiconductor having a uniform composition characteristic can be provided.

It is desirable except for the above-described manufacturing conditions that manufacturing parameters such as the temperature may be suitably selected and altered according to purposes.

This manufacturing apparatus will be described in more detail in accordance with the following embodiment.

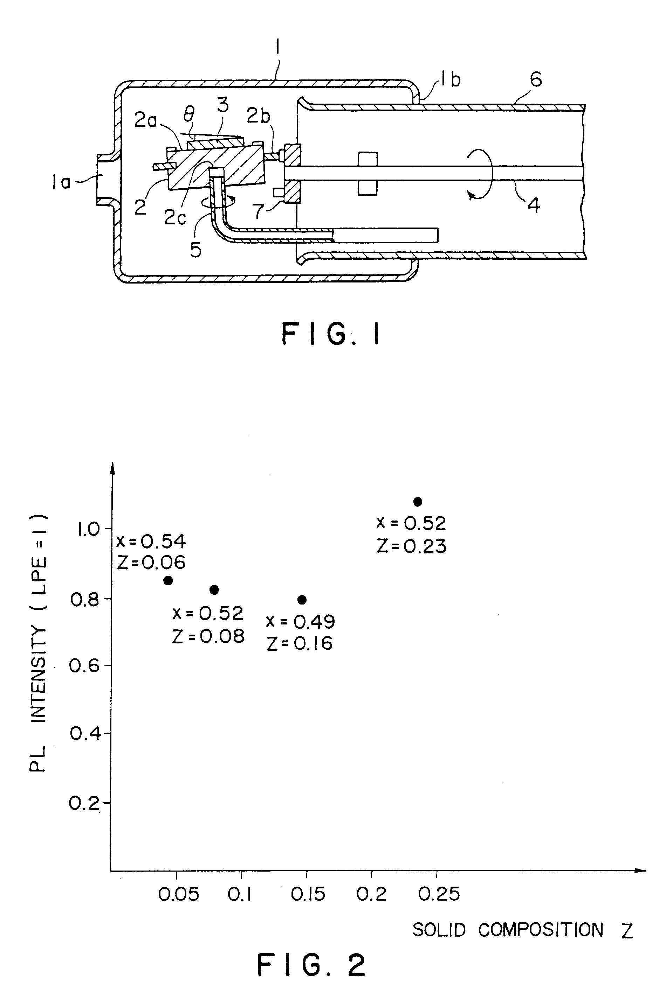

FIG. 1 is a side cross sectional view showing the principal part of an example of the lateral type reactive tube which can be used in the manufacturing method of this invention.

In this lateral type reactive tube, the mixture of material gases flows in a state considered as a laminar flow in a horizontal direction within the reactive tube.

At the substantially central portion of the inside of the lateral type reactive tube 1, a substrate table 2 is rotatably provided. In use, a substrate 3 on which a compound semiconductor crystal film is to be grown is mounted on the upper surface 2a of the substrate table 2. The substrate table 2 is of a structure such that it can have an angle ϑ of 3 to 45° relative to the flowing direction of the mixture of material gases, i.e., the horizontal direction, and is supported by a supporting shaft 5 inserted into a recess 2c.

A conduit 1a for the material gas is formed on the upstream side of the lateral type reactive tube 1, and an exhaust hole 1b for an exhaust gas is formed on the downstream side. Into the exhaust hole 1b, an exhaust pipe 6 is fitted.

At the central position of the exhaust pipe 6, a rotary shaft 4 is rotatably affixed. On the end portion on the side of the substrate table of the rotary shaft 4, a toothed wheel 7 is provided. This toothed wheel 7 meshes with a toothed portion 2b provided along the outer circumferential surface of the substrate table 2. Thus, it becomes operative in cooperation with the substrate table 2. The rotary shaft 4 is connected to a rotational drive surface (not shown) such as a motor.

The manufacturing apparatus illustrated is used as follows.

First, mixture of material gases adjusted so as to have a predetermined mixing ratio, is introduced from the conduit 1a into the lateral reactive tube 1 at a predetermined flow rate. The mixed gas thus introduced flows in a horizontal direction forming a steady laminar flow.

The rotary shaft 4 connected to a motor (not shown) provided outside the exhaust pipe transmits the rotational drive force to the toothed wheel 7. By the rotation of the toothed wheel 7, the substrate table 2 inclined at an angle ϑ and the substrate 3 mounted on the upper surface 2a of the substrate table rotate about the shaft (the supporting shaft 5) in a direction perpendicular to the substrate surface.

While the rotational speed of the substrate is arbitrary in this invention, it is preferable that the rotational speed is ordinarily set to less than 3 rpm in order to allow the compound semiconductor thus obtained to have an excellent performance.

### Semiconductor light emitting device

The semiconductor light emitting device manufactured according to this invention includes an active layer of a monocrystalline thin film comprised of a compound semiconductor expressed as the equation (Aℓ_{z}Ga_{1-z})ₓIn₁₋ₓP (x is a number where lattice-matching on the GaAs substrate can be realized, e.g., a number within a range from 0.48 to 0.55, and z is a number within a range from 0.08 to 0.25, preferably a number within a range from 0.18 to 0.25), and has an oscillating wavelength at least in the 606 nm band.

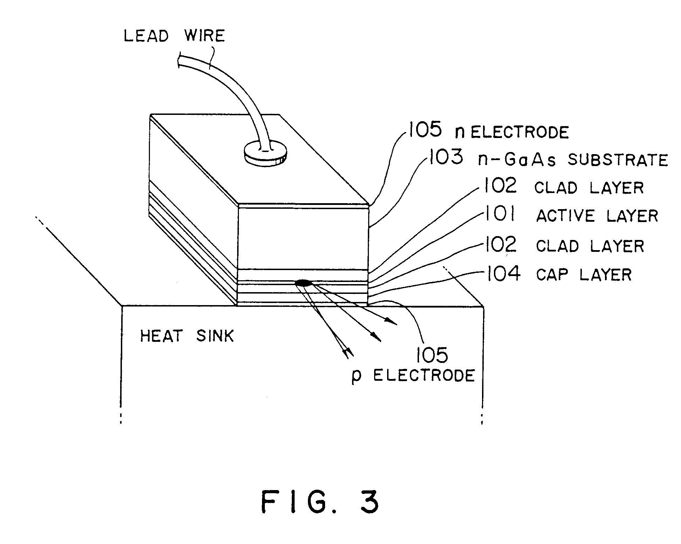

An example of the structure of a compound semiconductor laser according to this invention is shown in FIG. 3. In this example, the active layer 101 and the clad layer 102 which have been made to form a double hetero junction are epitaxially grown on the GaAs substrate 103. The clad layer 102 serves to confine carriers and photons in the active layer 101. The cap layer 104 is provided for reducing the contact resistance with the electrode portion 105. The pn junction is provided at the boundary between the active layer 101 and the clad layer 102.

The light emitting device manufactured according to this invention is not limited to the embodiment shown and may be implemented in various manners.

### Embodiment

This invention will be described in more detail in accordance with the following embodiments.

### First embodiment

In the first embodiment, an AℓGaInP compound semiconductor crystal film is formed on the substrate using the manufacturing apparatus provided with a lateral reactive tube of the structure shown in FIG. 1, to therefore manufacture a compound semiconductor light emitting device.

In the manufacturing apparatus used in the embodiment, a quartz glass tube having an inner diameter of 100 mm and a length of 650 mm was used as the reactive tube body, and carbon material (high purity carbon and SiC coated carbon) was used as the material of the substrate table (graphite susceptor).

A GaAs substrate having an area of 1 cm² as the substrate was mounted on the substrate table. The substrate surface was (100) planar.

The substrate table was inclined so that the substrate surface formed an angle of 5° relative to the horizontal direction of the material gas flow. The substrate table and the substrate mounted thereon were rotated about the supporting shaft. The rotational speed was 2/3 to 1 rpm.

The pressure within the reactive tube was set to 50 torr and the growth temperature (substrate temperature) of the compound semiconductor was set to 715 ± 10°C.

For the metalorganic compound including the group III device, trimethyl aluminum, trimethyl gallium and trimethyl indium were used. For hydride of phosphorous, phosphine was used.

The material gas so adjusted as to have a composition of the compound semiconductor (Aℓ_{z}Ga_{1-z})ₓIn₁₋ₓP [x=0.54, z=0.06] was introduced into the reactive tube at a gas velocity of 18 to 23 cm/sec. The compound semiconductor crystal film thus obtained was 1.0 µm (micron) in the film thickness, and the surface of the grown layer was spherical.

The light emitting intensity of the compound semiconductor crystal film thus obtained was evaluated.

Such an evaluation was conducted by measuring the light emitting intensity of photoluminescence of the compound semiconductor manufactured according to this invention, the light emitting intensity of photoluminescence of the laser oscillating compound semiconductor (Ga_{0.52}In_{0.18}As_{0.01}P_{0.99}) to be compared, with the semiconductor obtained by the liquid phase epitaxial (LPE) method, being used for a reference of 1.

The result is shown in FIG. 2. From these results it was seen that the compound semiconductor manufactured according to this invention exhibits a light emitting intensity comparable to that of the standard compound semiconductor.

The clad layer was further formed on the substrate on which the compound semiconductor film of the active layer was formed by the ordinary technique, to therefore prepare a semiconductor laser. The semiconductor laser thus prepared had an oscillating wavelength at least in the 606 nm band.

### Second embodiment

A method was employed to grow a compound semiconductor crystal film in the same manner as in the first embodiment except that the material gas was so prepared as to have a composition of the compound semiconductor (Aℓ_{z}Ga_{1-z})ₓIn₁₋ₓP [x=0.52, z=0.08] in the second embodiment. The light emitting intensity of the compound semiconductor crystal film thus obtained was evaluated, to therefore prepare a semiconductor laser.

The result of the evaluated light emitting intensity is shown in FIG. 2. From this evaluated result, it was confirmed that the compound semiconductor of this embodiment exhibits a light emitting intensity comparable to that of the reference compound semiconductor.

The semiconductor laser thus prepared has an oscillating wavelength at least in the 606 nm band.

### Third embodiment

A method was employed to grow a compound semiconductor crystal film in the same manner as in the first embodiment except that material gas was so prepared as to have a composition of the compound semiconductor (Aℓ_{z}Ga_{1-z})ₓIn₁₋ₓP [x=0.49, z=0.16] in the second embodiment. The light emitting intensity of the compound semiconductor crystal film thus obtained was evaluated, to therefore prepare a semiconductor laser.

The result of the evaluated light emitting intensity is shown in FIG. 2. From this calculated result, it was confirmed that the compound semiconductor of this embodiment exhibits a light emitting intensity comparable to that of the reference compound semiconductor.

The semiconductor laser thus prepared has an oscillating wavelength at least in the 606 nm band.

### Fourth embodiment

A method was employed to grow a compound semiconductor crystal film in the same manner as in the first embodiment except that material gas was prepared so as to have a composition of the compound semiconductor (Aℓ_{z}Ga_{1-z})ₓIn₁₋ₓP [x=0.52, z=0.23) in the second embodiment. The light emitting intensity of the compound semiconductor crystal film thus obtained was evaluated, to therefore prepare a semiconductor laser.

The result of the evaluated light emitting intensity is shown in FIG. 2. From this evaluated result, it was confirmed that the compound semiconductor of this embodiment exhibits a light emitting intensity superior to that of the reference compound semiconductor.

The semiconductor laser thus prepared has an oscillating wavelength at least in the 606 nm band.

## Claims

1. A method for forming an AlGaInP compound semiconductor crystal film on a substrate (3) to manufacture a compound semiconductor light emitting device, comprising the steps of:
- transporting, as source materials for the compound semiconductor crystal film, into a horizontal reactor a mixture of material gases, the mixture consisting of metalorganic compounds including the group III material and hydride of phosphorous;
- growing a monocrystalline thin film of a compound semiconductor expressed as the equation (Al_{z}Ga_{1-z})ₓIn₁₋ₓP, wherein x is a number where lattice-matching on the GaAs substrate is realized, and z is a number within a range from 0.08 to 0.25 on said substrate (3),
**characterized in that**
- said mixture of material gases flows in a horizontal direction within a lateral type reactive tube (1) at a gas velocity of less than 30cm/sec and at a pressure of less than 8·10³ Pa (60 Torr); and
- said substrate (3) for growing thereon said compound semiconductor crystal film is mounted on a substrate table (2) within said lateral type reactive tube (1) so that the surface of said substrate (3) has an angle of 3° to 45° relative to the horizontal direction to rotate said substrate table (2) about an axis in a direction perpendicular to said substrate surface.

2. A method of forming a semiconductor crystal film as set forth in claim 1, wherein the pressure within said lateral type reactive tube (1) at the time of growth of the compound semiconductor crystal film, is within a range from 6·10³ Pa to 7.3·10³ Pa (45 to 55 Torr).

3. A method of forming a semiconductor crystal film as set forth in claim 1 or 2, wherein said feed flow rate of said mixture of material gases at the time of growth of the compound semiconductor crystal film is 18 to 23 cm/sec.

4. A method of forming a semiconductor crystal film as set forth in any one of claims 1 to 3, wherein an angle defined by the flowing direction of said mixture of material gases and said substrate surface is 3 to 10°.

5. A method of forming a semiconductor crystal film as set forth in any one of claims 1 to 4, wherein x is a number within a range from 0.48 to 0.55.

6. A method of forming a semiconductor crystal film as set forth in any one of claims 1 to 5, wherein z is a number within a range from 0.18 to 0.25.

## Patentansprüche

1. Verfahren zur Bildung eines AlGaInP-Verbindung-HalbleiterknstallFilms auf einem Substrat (3) zur Herstellung einer Mischhalbleiter-Lichtemittier-Vorrichtung, folgende Schritte aufweisend:
- Transportieren einer Mischung aus Substanzgasen, die besteht aus metallorganischen Verbindungen einschließlich der Substanzen der Gruppe III und Phosphorhydrid, als Ausgangssubstanzen für den Mischhalbleiterkristall-Film, in einen horizontalen Reaktor;
- Wachsenlassen eines einkristallinen, dünnen Films aus einem Mischhalbleiter, ausgedrückt als die Gleichung (Al_{z}Ga_{1-z})ₓIn₁₋ₓP, in der x eine Zahl ist, bei der Gitter-Anpassung auf dem GaAs-Substrat verwirklicht wird, und z eine Zahl im Bereich von 0,08 bis 0,25 ist, auf dem Substrat(3),
dadurch gekennzeichnet, daß
- die Mischung aus Substanzgasen in einem Quer-Reaktionsrohr (1) in einer horizontalen Richtung strömt mit einer Gasgeschwindigkeit von weniger als 30 cm/Sekunde und bei einem Druck von weniger als 8x10³ Pa (60 Torr); und
- das Substrat (3), auf dem der Mischhalbleiterkristall-Film wachsen soll, in dem Quer-Reaktionsrohr (1) so auf einem Substrattisch (2) befestigt wird, daß die Oberfläche des Substrats (3) relativ zur horizontalen Richtung einen Winkel von 3° bis 45° aufweist, um den Substrattisch (2) um eine Achse in einer zu der Substratoberfläche senkrechten Richtung zu drehen.

2. Verfahren zur Bildung eines Halbleiterkristall-Films wie in Anspruch 1 dargelegt, bei dem der Druck in dem Quer-Reaktionsrohr (1) zur Zeit des Wachstums des Mischhalbleiterkristall-Films in einem Bereich von 6x10³ Pa bis 7,3 x 10³ Pa (45-55 Torr) ist.

3. Verfahren zur Bildung eines Halbleiterkristall-Films wie in Anspruch 1 oder 2 dargelegt, bei dem die Einspeise-Strömungsgeschwindigkeit der Mischung aus Substanzgasen zur Zeit des Wachstums des Mischhalbleiterkristall-Films 18-23 cm/Sekunde ist.

4. Verfahren zur Bildung eines Halbleiterkristall-Films wie in einem der Ansprüche 1 bis 3 dargelegt, bei dem ein durch die Strömungsrichtung der Mischung aus Substanzgasen und die Substratoberfläche definierter Winkel 3 bis 10° ist.

5. Verfahren zur Bildung eines Halbleiterkristall-Films wie in einem der Ansprüche 1 bis 4 dargelegt, bei dem x eine Zahl in einem Bereich von 0,48 bis 0,55 ist.

6. Verfahren zur Bildung eines Halbleiterkristall-Films wie in einem der Ansprüche 1 bis 5 dargelegt, bei dem z eine Zahl in einem Bereich von 0,18 bis 0,25 ist.

## Revendications

1. Un procédé de formation d'un film cristallin semi-conducteur composé en AlGaInP sur un substrat (3) afin de fabriquer un dispositif émetteur lumineux semi-conducteur composé, comprenant les étapes consistant à:
- transporter vers un réacteur horizontal, comme matière de source du film cristallin semi-conducteur composé, un mélange de matières gazeuses, le mélange consistant en composés métallo-organiques incluant la matière du groupe III et l'hybride de phosphore;
- faire croître un mince film monocristallin d'un semi-conducteur composé, exprimé par l'équation (Al_{z}Ga_{1-z})ₓIn₁₋ₓP où x est un nombre où est réalisée une concordance de réseau du substrat en GaAs et z est un nombre compris dans la plage de 0,08 à 0,25 sur ledit substrat (3),
caractérisé en ce que
ledit mélange de matières gazeuses s'écoule dans une direction horizontale à l'intérieur d'un tube de réaction (1) du type latéral à une vitesse de gaz inférieure à 30 cm/sec et à une pression inférieure à 8.10³ Pa (60 Torr); et
ledit substrat sur lequel doit se faire la croissance dudit film cristallin semi-conducteur composé est monté, d'une façon telle que la surface dudit substrat (3) forme un angle de 3° à 45° par rapport à la direction horizontale, sur une table (2) de substrat à l'intérieur dudit tube de réaction (1) du type latéral de manière à faire tourner ladite table de substrat (2) autour d'un axe dans une direction perpendiculaire à ladite surface de substrat.

2. Un procédé de formation d'un film cristallin semi-conducteur selon la revendication 1, dans lequel la pression à l'intérieur dudit tube de réaction de type latéral est comprise, lors de la croissance du film cristallin semi-conducteur composé, dans une plage allant de 6.10³ Pa à 7,3.10³ Pa (45 à 55 Torr).

3. Un procédé de formation d'un film cristallin semi-conducteur selon la revendication 1 ou 2, dans lequel ledit débit d'alimentation dudit mélange de matières gazeuses est compris, lors de la croissance du film cristallin semi-conducteur composé, entre 18 et 23 cm/sec.

4. Un procédé de formation d'un film cristallin semi-conducteur selon l'une quelconque des revendications 1 à 3, dans lequel un angle défini par la direction d'écoulement dudit mélange de matières gazeuses et ladite surface de substrat est compris entre 3 et 10°.

5. Un procédé de formation d'un film cristallin semi-conducteur selon l'une quelconque des revendications 1 à 4, dans lequel x est un nombre compris dans une plage allant de 0,48 à 0,55.

6. Un procédé de formation d'un film cristallin semi-conducteur selon l'une quelconque des revendications 1 à 5, dans lequel z est un nombre compris dans une plage allant de 0,18 à 0,25.
